# EUROPEAN PATENT APPLICATION

(11) **EP 2 647 741 A2**
(43) Date of publication of application: **09.10.2013**
(21) Application number: 12166022.9
(22) Date of filing: 27.04.2012
(51) Int. Cl.: C30B 15/06, C30B 29/06, C30B 28/10, C30B 35/00

(54) **Apparatus for manufacturing silicon substrate**

(30) Priority: 05.04.2012 KR 20120035456
(71) Applicant: Korea Institute of Energy Research, Daejeon 305-343 (KR)
(72) Inventor: Lee, Jin Seok, 305-768 DAEJEON (KR); Jang, Bo Yun, 305-350 DAEJEON (KR); Kim, Joon Soo, 305-313 DAEJEON (KR); Ahn, Young Soo, 305-509 DAEJEON (KR)
(74) Representative: Colombo, Michel

(57) **Abstract**

There is disclosed an apparatus for manufacturing a silicon substrate including a crucible part, a molding part extended from an outlet of the crucible part, the molding part comprising a molding space where a silicon substrate is formed, and a dummy bar inserted in the molding space from a predetermined portion of the molding part, wherein the dummy bar is formed of a single-crystalline material.

## Description

[TECHNICAL FIELD]

Embodiments may relate to an apparatus for manufacturing a silicon substrate, more particularly, to an apparatus for manufacturing a silicon substrate for a solar battery, using continuous casting.

[BACKGROUND]

Generally, silicon is molted and molten silicon is solidified to fabricate a single-crystalline silicon ingot or polycrystalline silicon block. The single-crystalline silicon ingot or polycrystalline silicon block is cut and a silicon substrate is manufactured.

The single-crystalline silicon ingot is fabricated according to Czochralski method through a crystalline growth process using seed crystals from silicon molten.

The polycrystalline block is fabricated through a single-direction solidification process according to Heat Exchanger (HEM) or Bridman-Stockbarger method.

The fabricated single-crystalline silicon Ingot or polycrystalline silicon block is manufactured into a silicon substrate through various cutting processes.

During the cutting process of the single-crystalline ingot or polycrystalline silicon block, 40∼50% of Kerf-loss might be generated. Accordingly, there is a disadvantage of increased production cost for a silicon substrate for a solar battery that is caused by the Kerf-loss generated during the process of manufacturing the silicon substrate.

To solve the disadvantage there have been active studies on a method of directly manufacturing a thin silicon substrate from molten silicon, without the ingot cutting process.

Currently, direct manufacturing technique with respect to a silicon substrate for a solar battery can be categorized into a vertical growth technique and a horizontal growth technique. A conventional vertical growth technique includes edge-defined film-fed growth (EFG), string ribbon (SR). The horizontal growth technique includes ribbon growth on substrate (RGS) and crystallization on dipped substrate (CDS).

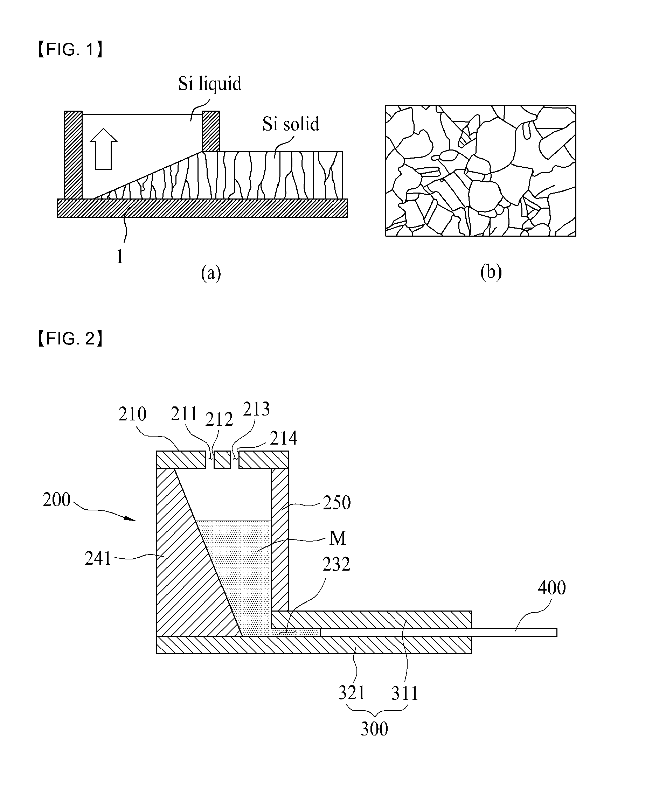

FIG. 1 includes a schematic diagram illustrating an apparatus for manufacturing a silicon substrate manufactured according to RGS technique for directly manufacturing a silicon substrate from molten silicon in a horizontal direction and a diagram illustrating a fine structure of the silicon substrate fabricated according to the RGS technique.

In the RGS technique, a latent heat of the molten silicon moving via a lower substrate 1 is removed rapidly, to manufacture a silicon substrate. Such the RGS technique has high productivity, compared with other methods for directly manufacturing the silicon substrate. However, if manufacturing the silicon substrate according to the RGS method, a crystalline growth direction of the silicon substrate is perpendicular to a direction of moving the silicon substrate. Accordingly, grains happen to grow within the thickness of the silicon substrate.

Also, as shown in FIG. 1 (a), the crystalline growth direction of silicon is perpendicular to the silicon substrate moving direction. As shown in FIG. 1 (b), grains are densely closed and solidification is performed along a solid-liquid interface such that impurities might be concentrated on a surface of the silicon substrate. Accordingly, there might be a problem of deteriorated conversion efficiency in the manufactured solar battery.

Meanwhile, in a conventional vertical growth technique, a direction of manufacturing a silicon substrate is in parallel to a direction of crystalline growth. Accordingly, the size of a crystalline grain generated in the silicon substrate is large enough to enhance conversion efficiency. However, the conventional vertical growth technique has a problem of low productivity, because the silicon solidification speed is quite slow.

In the conventional direct manufacturing technique with respect to a silicon substrate, silicon substrate productivity and energy conversion efficiency are in trade-off. Accordingly, there are demands on a silicon substrate manufacturing technique that is able to enhance both productivity and quality of the silicon substrate.

[PRIOR ART DOCUMENTS]

Korean Registered Patent No. 10-1080757

Japan Publicized Patent No. 1995-256624

[DISCLOSURE]

[TECHNICAL PROBLEM]

To solve the problems, an object of the invention is to provide an apparatus for manufacturing a silicon substrate that can make a solid-liquid interface to be perpendicular to a crystal growth direction of silicon in manufacturing a silicon substrate and that can control the grain size of silicon to be enlarged.

Another object of the invention is to provide an apparatus for manufacturing a silicon substrate that can manufacture a silicon substrate having enhanced conversion efficiency according to a continuous casting method capable of enabling continuous production and physical control, with enhancing productivity simultaneously.

[TECHNICAL SOLUTION]

In an aspect of the invention, an apparatus for manufacturing a silicon substrate includes a crucible part; a molding part extended from an outlet of the crucible part, the molding part comprising a molding space where a silicon substrate is formed; and a dummy bar inserted in the molding space from a predetermined portion of the molding part, wherein the dummy bar is formed of a single-crystalline material.

The single-crystalline material may be single-crystalline silicon.

The apparatus for manufacturing the silicon substrate may further include a dummy bar coupling part that is able to be coupled to the dummy bar.

The apparatus for manufacturing the silicon substrate may further include a driving part to drive the dummy bar coupling part to be movable in a longitudinal direction of the molding part.

The crucible part may include a top surface, side surfaces extended from the top surface in a downward direction, a bottom surface extended from the side surfaces in a perpendicular direction and an inclined part having a slope of an acute angle with respect to one of the side surfaces.

The apparatus for manufacturing the silicon substrate may further include a closable part arranged adjacent to the molding part to cover an outside of the dummy bar coupling part, the closable part that is expandable and contractible in a longitudinal direction of the dummy bar.

The crucible part may include a first crucible part and a second crucible part, and the first crucible part may include a top surface, side surfaces extended from the top surface in a downward direction, a bottom surface extended from the side surfaces in a perpendicular direction and a first outlet formed through a predetermined portion thereof in a parallel direction with respect to the bottom surface, and the second crucible part may be insertedly coupled to the first crucible part and the second crucible part may include a second inclined part connected with the bottom surface, with a slope of an acute angle with respect to an upper portion of the top surface provided in the first crucible part.

The apparatus for manufacturing the silicon substrate may further include a main chamber to provide an airtight space, wherein the crucible part comprises a raw material injecting part provided in the main chamber, having a raw material injecting hole passing through an upper portion thereof, and a gas injecting part spaced apart a predetermined distance from the raw material injecting hole, having a gas injecting hole passing through an upper portion thereof; a raw material supplying part comprising a raw material supplying body arranged on the main chamber to store a silicon raw material, a raw material supplying pipe to connect the raw material supplying body and the raw material injecting part with each other and a first valve to control opening and closing of the raw material supplying pipe; and a gas supplying part to supply an inert gas to the crucible part.

In another aspect of the invention, an apparatus for manufacturing a silicon substrate includes a crucible part to form molten silicon therein, the crucible part comprising an outlet formed through a predetermined portion thereof in a parallel direction with respect to a bottom surface thereof; a molding part extended from the outlet in a parallel direction with respect to the outlet of the crucible part, the molding part comprising a molding space where a silicon substrate is formed; and a dummy bar inserted in the molding part, wherein the dummy bar is formed of single-crystalline to enable a solid-liquid interface generated in forming the silicon substrate to be substantially perpendicular to a direction in which the silicon substrate is formed.

The apparatus for manufacturing the silicon substrate may further include a dummy bar coupling part that is able to be coupled to the dummy bar.

The crucible part may include a top surface, side surfaces extended from the top surface in a downward direction and an inclined part having a slope of an acute angle with respect to one of the side surfaces.

The apparatus for manufacturing the silicon substrate may further include a closable part to close the dummy bar and an outside of the dummy bar coupling part to prevent fluidal molten silicon from contacting with external air in the molding space.

The crucible part may include a first crucible part and a second crucible part, and the crucible part has an inlet to charge a silicon raw material therein and a first outlet formed through a predetermined portion thereof in a parallel direction with respect to the bottom surface, and the second crucible part may have a corresponding appearance to the first crucible part, with being insertedly coupled to the first crucible part, and an internal cross section area of the second crucible part may be gradually decreased in a downward direction.

The crucible part may include an injecting hole passing through an upper portion of the crucible part, and the crucible part may further include a raw material supplying part to supply a silicon raw material to the injecting part; and a gas supplying part to supply gas to the injecting part, and the silicon raw material and the gas is selectively supplied to the injecting part.

In a further aspect of the invention, an apparatus for manufacturing the silicon substrate includes a crucible part comprising an outlet formed through a predetermined portion thereof in a parallel direction with respect to a bottom surface thereof; a molding part extended from the outlet in a parallel with respect to the outlet of the crucible part, the molding part comprising a molding space where a silicon substrate is formed; and a dummy bar inserted in the molding space from a predetermined portion of the molding part, wherein an end of the dummy bar is formed of a single-crystalline material.

The ingle-crystalline material may be single-crystalline silicon.

In a still further aspect of the invention, an apparatus for manufacturing the silicon substrate includes a crucible part to accommodate molten silicon; a molding part physically connected with the crucible part, to form a silicon substrate; and a dummy bar having a single-crystalline material to align grains of a silicon substrate in a single direction, when a silicon substrate is formed in the molding part.

The single direction of the aligned grains of the silicon substrate formed in the molding part may be a longitudinal direction of the molding part.

[ADVANTAGEOUS EFFECTS]

The embodiments have following advantageous effects.

First, the silicon substrate is formed by using the single-crystalline dummy bar, different from the conventional silicon substrate manufacturing apparatus including a lower substrate that removes a latent heat of molten silicon to solidify the molten silicon in a molding part via a crucible part. Accordingly, the size of the grains generated in the silicon substrate may be enlarged.

Second, the single-crystalline dummy bar inserted in the molding part is used. Accordingly, the growth direction of the silicon grains and the solid-liquid interface may be perpendicular to each other, to enlarge the size of the grains in the silicon substrate.

Finally, different from the conventional direct silicon substrate manufacturing method, the silicon substrate is pulled horizontally. Accordingly, productivity may be enhanced.

[BRIEF DESCRIPTION OF THE DRAWINGS]

Arrangements and embodiments may be described in detail with reference to the following drawings in which like reference numerals refer to like elements and wherein:

FIG. 1 FIG. 1 includes a schematic diagram illustrating an apparatus for manufacturing a silicon substrate manufactured according to RGS technique for directly manufacturing a silicon substrate from molten silicon in a horizontal direction and a diagram illustrating a fine structure of the silicon substrate fabricated according to the RGS technique;

FIG. 2 is a diagram schematically illustrating an apparatus for manufacturing a silicon substrate according to an embodiment of the invention;

FIG. 3 is a perspective view illustrating a crucible part shown in FIG. 2;

FIG. 4 is a sectional view illustrating an apparatus for manufacturing a silicon substrate according to another embodiment of the invention;

FIG. 5 is an exploded perspective view of FIG. 4;

FIG. 6 is a diagram illustrating an apparatus for manufacturing a silicon substrate according to a further embodiment of the invention;

FIG. 7 is a diagram illustrating an apparatus for manufacturing a silicon substrate according to a still further embodiment of the invention;

FIG. 8 is a diagram specifically illustrating the apparatus for manufacturing the silicon substrate according to the embodiment;

FIG. 9 is a sectional view illustrating a molding part shown in FIG. 8;

FIG. 10 is a diagram schematically illustrating an apparatus for manufacturing a silicon substrate according to a still further embodiment of the invention;

FIG. 11 is a diagram schematically illustrating a moving direction of a dummy bar shown in FIG. 10 and a grain of the silicon substrate;

FIG. 12 is a diagram a diagram illustrating an apparatus for manufacturing a silicon substrate according to a still further embodiment of the invention;

FIG. 13 is a diagram a diagram illustrating an apparatus for manufacturing a silicon substrate according to a further embodiment of the invention; and

FIG. 14 is a diagram illustrating a closable part shown in FIG. 13 that is unfolded.

[BEST MODE]

As follows, embodiments will be described in detail to be embodied by those skilled in the art to which the embodiments pertain to, in reference to the accompanying drawings. Reference may now be made in detail to specific embodiments, examples of which may be illustrated in the accompanying drawings.

Wherever possible, same reference numbers may be used throughout the drawings to refer to the same or like parts.

Unless specific definition, meaning of all terminology used in the present specification is identical to common meaning of terminology people skilled in the art to which the present invention pertains may understand and not intended to limit the invention. Unless meaning thereof is defined specifically, a singular expression used in the specification includes a plural form. If there is collision between definition of the terminology used in the present specification and definition of the conventional terminology, definition used in the present invention has priority. Any reference in this specification to "comprise," or "include" means that there are a characteristic, a number, a step, an operation, an element, a part or combination thereof and not exclude one or more other characteristics, numbers, steps, operations, elements, parts or combinations thereof and additional possibility.

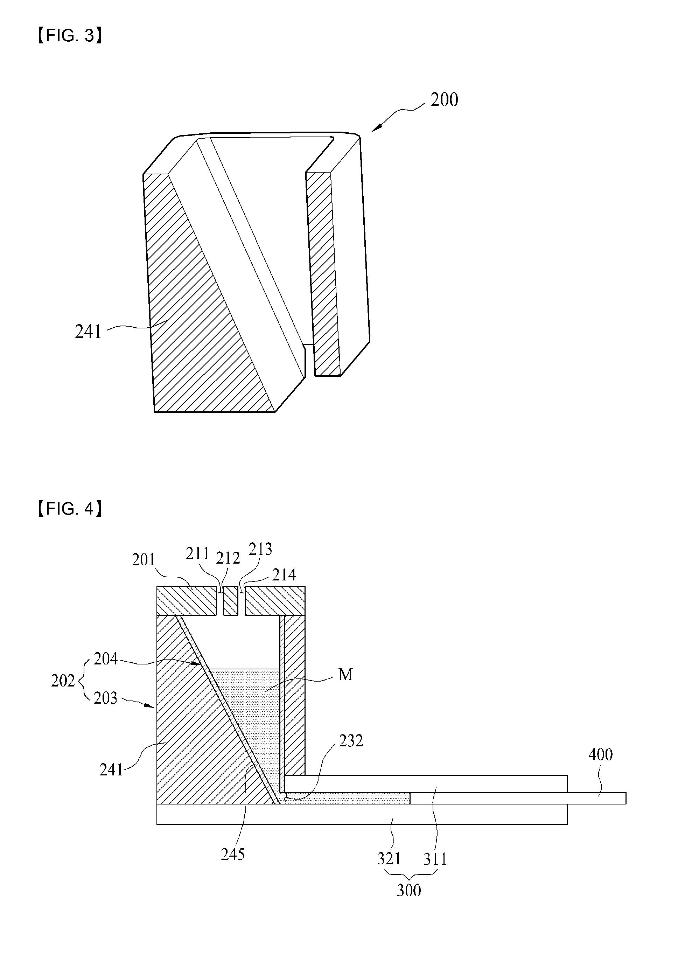

FIG. 2 is a diagram schematically illustrating an apparatus for manufacturing a silicon substrate according to an embodiment of the invention. FIG. 3 is a perspective view illustrating a crucible part shown in FIG. 2.

In reference to FIGS. 2 and 3, an apparatus for manufacturing a silicon substrate (hereinafter, a silicon substrate manufacturing apparatus) includes a crucible part 200 and a molding part 300.

The crucible part 200 includes a top surface 210, side surfaces 250 and an inclined part 241.

The crucible part 200 may be defined by the top surface 210, the side surfaces 250 downwardly extended from the top surface 210 and the inclined part 241 having a slope of an acute angle with respect to one of the side surfaces 250. The crucible part 200 may be formed of graphite.

In a different aspect of the invention, an internal cross sectional area of the crucible part 200 may be gradually decreased in a downward direction.

The inclined part 241 may be longer in a downward direction than a side surface 250 located in opposite. Accordingly, a groove does not have to be formed in the crucible part 200 coupled to the molding part, which will be described later, to exhaust molten silicon.

In addition, the inclined part 241 may be integrally or independently formed with the side surface 250.

Meanwhile, different from what is shown in the drawings, the crucible part may be defined by the top surface 210, the side surfaces 250 extended from the top surface 210 in a downward direction and a bottom surface extended from the side surfaces 250 in a perpendicular direction.

The crucible part may provide a closed internal space.

Also, an inclined part is connected with the bottom surface, with a slope of an acute angle with respect to one of the side surfaces 250.

Meanwhile, silicon carbide (SiC) or silicon nitride (Si3N4) may be coated on an internal space of the crucible part 200. Accordingly, when the crucible part 200 is formed of graphite, contamination of silicon molten (M) may be prevented that might be caused by the graphite of the crucible part.

The molding part 300 includes a first molding part 311 and a second molding part 321.

The first molding part 311 may be extended from the side surface 250 facing the inclined part 241 in a perpendicular direction.

The second molding part 321 is coupled to the inclined part 241, extended in parallel to the first molding part 311.

Although not shown in the drawings, the inclined part 241 and the second molding part 321 are coupled to each other by a bolt.

Accordingly, the second molding part 321 may be employed as a bottom of the crucible part 200.

A molding space is formed between the first molding part 311 and the second molding part 321.

Also, the first molding part 311 and the second molding part 321 may form an outlet 232 to suck the molten silicon (M) stored in the crucible part 200.

A predetermined area of an upper surface adjacent to an end of the first molding part 311 may be in contact with an end of the side surface 250 facing the inclined part.

When the internal space of the molding part 300 is pressed at a high pressure than the internal space of the crucible part 200 by the molten silicon (M) is drawn into the molding space via the outlet 232, the internal space of the molding part may prevent the molten silicon (M) from flowing out, compared with the end of the first molding part 311 in contact with an outer surface of the side surface 250.

Different from what is shown in the drawings, the end of the inclined part 241 may be in contact with an extended line in a perpendicular direction with respect to the side surface 250 facing the inclined part 241.

Accordingly, when the molten silicon (M) is not stored in the crucible part 200 continuously, the molten silicon (M) may be prevented from remaining in the crucible part 200.

The molten silicon (M) is transported to the molding part 300 via the outlet 232.

The fluidal silicon molten (M) may be solidified in the molding part 232, to be a silicon substrate.

Detailed description of the molding part will be made later in reference to corresponding drawings.

Meanwhile, the silicon substrate manufacturing apparatus according to this embodiment of the invention may further include a dummy bar 400.

An end of the dummy bar 400 is in contact with the molten silicon (M) to solidify the molten silicon (M).

Meanwhile, different from what is shown in the drawings, the silicon substrate manufacturing apparatus according to the embodiment may solidify the molten silicon (M), without the dummy bar 400.

When silicon raw material is charged into the crucible part 200 to form the molten silicon (M) in the silicon substrate manufacturing apparatus according to the embodiment, the molten silicon (M) inside the crucible part 200 may press the molten silicon (M) located in a lower area of the crucible part 200 adjacent to the outlet 232 along the inclined part 240.

In other words, compared with the crucible part having no inclined part, the molten silicon (M) is pressed toward the lower area of the crucible part having the inclined part and is can move toward the outlet 232 smoothly.

As a result, the silicon substrate manufacturing apparatus according to this embodiment includes the inclined part 240 formed in the crucible part 200 to make the cross section area inside the crucible part decreased in the downward direction, such that the molten silicon may press the lower area of the crucible part.

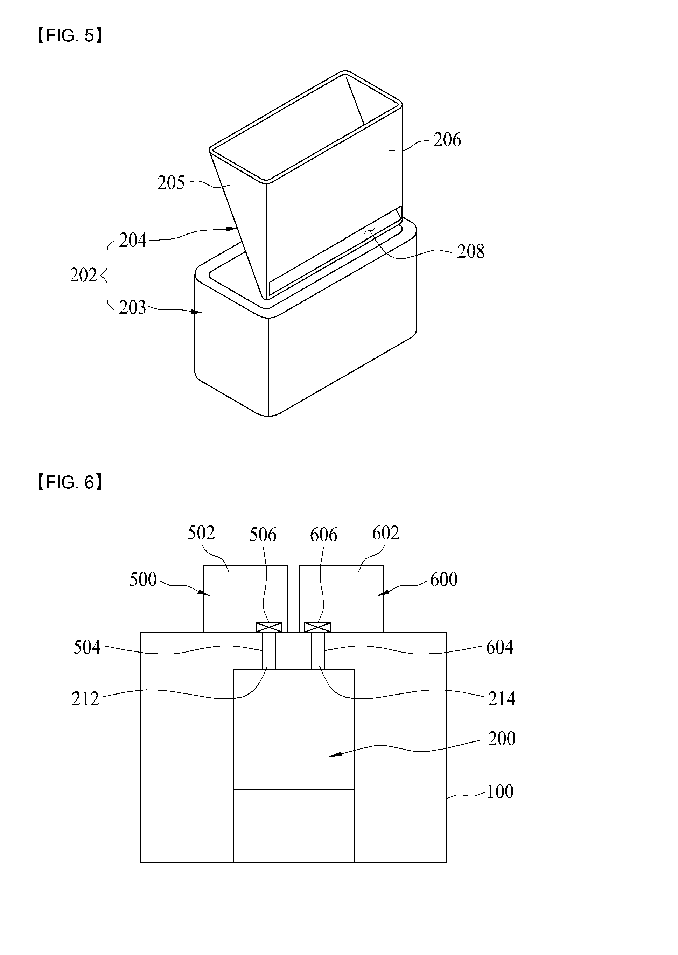

FIG. 4 is a sectional view illustrating a silicon substrate manufacturing apparatus according to another embodiment of the invention. FIG. 5 is an exploded perspective view of a crucible part shown in FIG. 4.

A silicon substrate manufacturing apparatus according to this embodiment is similar to the apparatus according to the embodiment shown in FIG. 3 and the description of the same component elements thereof will be omitted accordingly.

In reference to FIGS. 4 and 5, a crucible part 202 applied to this embodiment includes a first crucible part 203 and a second crucible part 204.

The first crucible part 203 may be defined by an upper surface 210, side surfaces 250 extended from the upper surface 210 and a first inclined part 241 having a slope of an acute angle with respect to one of the side surfaces 250. Different from the crucible part 200 according to the embodiment mentioned above, the first crucible part 203 may have the inclined part.

The first crucible part 203 may be formed of graphite.

The second crucible part 204 may be provided in the first crucible part 203 and it may have a second inclined part 245 corresponding to the first inclined part 241.

A crucible part 300 according to this embodiment is identical to the crucible part provided in the silicon substrate manufacturing apparatus according to the embodiment mentioned above and detailed description thereof will be omitted.

An end of the second inclined part 245 may be in contact with a line extended in a perpendicular direction with respect to the side surface 250 facing the second inclined part 245.

Accordingly, molten silicon (M) may be prevented from remaining inside the crucible part 200 if molten silicon (M) is not stored in the crucible part 200 continuously.

In addition, the second inclined part 245 of the second crucible part may be longer than the side surface 250 facing the second inclined part in a downward direction.

The second crucible part 204 may be formed of quartz and the material used for the second crucible may not be limited thereto. The second crucible part 204 may be formed of any materials capable of preventing the molten silicon from being contaminated by the first crucible part 203.

Meanwhile, SiC or Ni3N4 may be coated on the first crucible part 203.

Accordingly, when the second crucible part 204 is a quartz crucible, graphite and quartz physically contact with each other only to prevent SiO or Co gas from being generated from an interface.

In a different aspect of the invention, a cross section area inside the second crucible part 203 may be gradually decreased in a downward direction.

The crucible part 202 applied to the silicon substrate manufacturing apparatus according to this embodiment includes the second crucible part 204 capable of shutting off carbon from penetrating into the molten silicon (M), when the first crucible part 203 is a graphite crucible. Accordingly, contamination of the molten silicon (M) can be prevented.

Meanwhile, different from the embodiment mentioned above, the second crucible part may have the inclined internal structure, although the first crucible part has no inclined structure. Accordingly, the molten silicon may move via the outlet smoothly.

FIG. 6 is a diagram illustrating a silicon substrate manufacturing apparatus according to a further embodiment of the invention.

In reference to FIG. 6, the silicon substrate manufacturing apparatus according to this embodiment includes a main chamber 100, a crucible part 200, a raw material supplying part 500 and a gas supplying part 600.

The main chamber 100 provides an airtight closable space and it is closable at a predetermined side although not shown in the drawing.

The crucible part 200 may be one of the crucible parts described in the embodiments mentioned above and it may include a raw material injecting part 212 and a gas injection part 214.

As shown in FIG. 2, the raw material injection part 212 may include a raw material injecting hole 211 passing through a top of the crucible part.

The gas injecting part 214 may include a gas injecting hole 213 passing through the top of the crucible part 200, spaced apart a predetermined distance from the raw material injecting hole.

The raw material supplying part 500 may include a raw material supplying body 502, a raw material supplying pipe 504 and a first valve 506.

The raw material body 502 may be arranged on the main chamber 100 to store silicon raw material such that a predetermined amount of silicon raw material may be exhausted via an outlet formed through a bottom surface of the raw material body 502 regularly.

The raw material supplying pipe 504 passes through a top surface of the main chamber 100 to connect a bottom of the raw material supplying body 502 and the raw material injection part 212 of the crucible part 200 with each other, such that the silicon raw material exhausted from the raw material supplying body 502 may be supplied to the internal space of the crucible part 200.

The first valve 506 may be arranged between the raw material supplying body 502 and the raw material supplying pipe 504. Also, the first valve 506 may be arranged on the main chamber 100 and it may be distant from the crucible part, to prevent damage generated by the heat.

In addition, when the silicon raw material is supplied to the crucible part 200, the first valve 506 is open. When an inert gas is supplied from the top of the main chamber 100, the first valve 506 is closed. Accordingly, the inert gas may not be detained in the raw material supplying body 502 via the raw material supplying pipe 504.

The gas supplying part 600 may include a gas generator 602, a gas supplying pipe 604 and a second valve 606.

The gas generator 602 may generate an inert gas having a low reactivity with graphite such as argon (Ar) or it may provide a predetermined space to store the inert gas.

The gas supplying pipe 604 may passes through the top of the main chamber 100 to connect the gas generator 602 and the gas injecting part 214 of the crucible part with each other, to supply the inert gas to the crucible part 200 from the gas generator 602.

Meanwhile, different from the gas supplying part, the gas supplying part may not include the gas supplying pipe.

Accordingly, an internal space of the main chamber 100 is pressed by the inert gas supplied from the gas generator 602 and the inert gas is supplied from the main chamber 100 via the gas injecting part 214, such that an entire space inside both of the main chamber and the crucible part 200 may be pressed by the inert gas.

The inert gas may press the internal space of the crucible part 200 to exhaust the molten silicon (M) via the outlet 232 shown in FIG. 2 smoothly.

When the temperature of the molten silicon (M) is low, fluidity of the molten silicon is deteriorated and the inert gas may not press too much.

As a result, the internal pressure of the crucible part 200 enabled by the inert gas may be 1∼5 bar to exhaust the molten silicon (M) via the outlet 232, when the fluidity of the molten silicon is deteriorated too much, and to prevent a pore from being generated in the molten silicon (M) by the high pressure of the inert gas.

The second valve 606 may be arranged between the gas generator 602 and the gas supplying pipe 604. The second valve 606 may be arranged on the main chamber 100.

When the inert gas is supplied to the crucible part 200, the first valve is closed and the second valve is open.

Accordingly, when the inert gas increases the internal pressure of the crucible part 200, the first valve 506 is closed to prevent the inert gas from pressing the inside of the raw material supplying body 502 after drawn therein.

The silicon substrate manufacturing apparatus according to this embodiment can prevent the manufacture cost of the raw material body 502 from increasing to have the material or structure that enables the raw material supplying body 502 to endure the pressed inert gas.

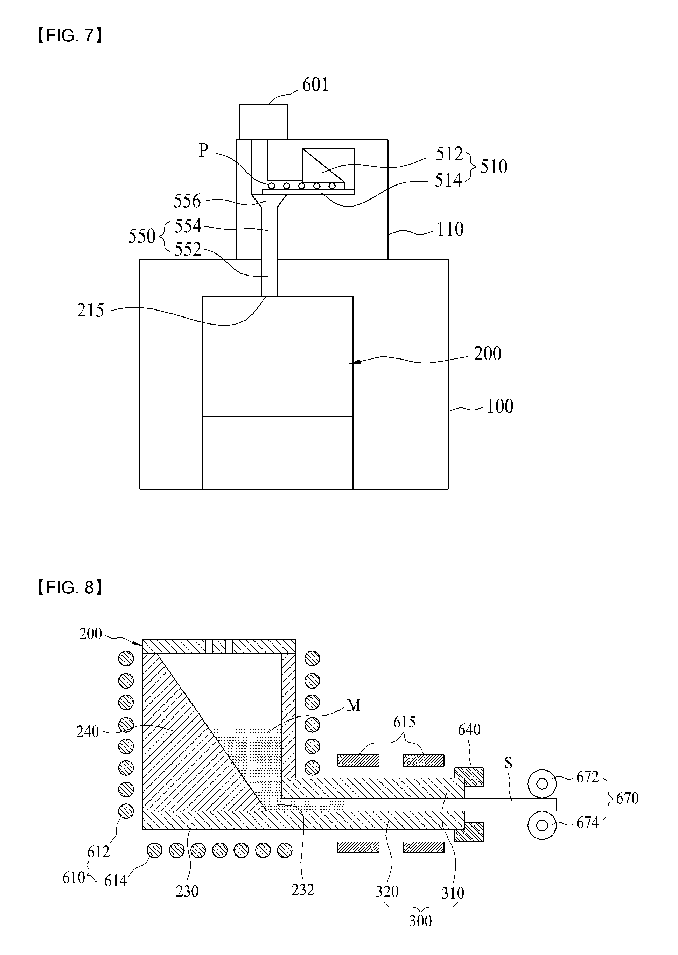

FIG. 7 is a diagram illustrating a silicon substrate manufacturing apparatus according to a still further embodiment of the invention.

In reference to FIG. 7, the silicon substrate manufacturing apparatus according to this embodiment of the invention includes a main chamber 100, an auxiliary chamber 110, a crucible part 200, a raw material supplying part 501 and a gas supplying part 601.

The main chamber 100 provides an airtight space and it is closable at a predetermined side.

The crucible part 200 may be similar to one of the embodiments mentioned above. The crucible part 200 according to this embodiment includes a single injecting part 215 to inject the silicon raw material and the inert gas there through, without the raw material injecting part and the gas injecting part 214 mentioned above independently.

The raw material supplying part 501 may include a raw material supplying body 510 and a supplying pipe 550.

The raw material supplying body 510 may be installed in the auxiliary chamber 110 and it includes a raw material storing part 512 and a raw material moving part 514.

The raw material storing part 512 provides a predetermined space to store the silicon raw material (P).

The raw material moving part 514 may be connected with the raw material storing part 512 and it may move a predetermined amount of silicon raw material (P) regularly.

The supplying pipe 550 is connected with the injecting part 215 of the crucible part, adjacent to an end of the raw material moving part 514.

The supplying pipe 550 includes a first supplying pipe 552 and a second supplying pipe 554.

The first supplying pipe 552 may define a lower part of the raw material supplying pipe 550 and it may be arranged in the main chamber 100.

In addition, the first supplying pipe 552 may be formed of graphite and it may prevent the raw material from being damaged by the heat in the high temperature chamber 100.

The second supplying pipe 554 may define an upper part of the raw material supplying pipe 550 and it may be arranged in the auxiliary chamber 110.

In addition, the second supplying pipe 554 is formed of stainless steel. The material used for the second supplying pipe 554 is not limited thereto and it may be any metal that is able to endure the heat inside of the auxiliary chamber 110, with high anticorrosion.

The supplying pipe 550 may further include a supplying part upper end 556 extended from the second supplying pipe 554, with a cross sectional area gradually increasing in an upward direction.

Accordingly, the silicon raw material (P) moved to the raw material moving part 514 may be supplied to the supplying pipe 550 smoothly.

The gas supplying part 601 may be provided adjacent to the auxiliary chamber 110 and it may generate an inert gas or provide a predetermined space to store the inert gas.

In addition, the auxiliary chamber 110 may have a hole formed there through to receive the inert gas from the gas supplying part 601.

When the inert gas is supplied to the auxiliary chamber 110 from the gas supplying part 601, the inert gas may press an internal space of the auxiliary chamber 110 and the crucible part 200 via the supplying pipe 550 simultaneously.

The auxiliary chamber 110 and the raw material supplying part 501 may be formed of a predetermined material capable of enduring the pressure generated by the inert gas.

The silicon substrate manufacturing apparatus according to this embodiment may selectively supply the silicon raw material and the inert gas to the crucible part 200 via the single supplying pipe 550, different from the silicon substrate manufacturing apparatus according to the embodiment shown in FIG. 6.

Furthermore, the silicon raw material and the inert gas are supplied via the single supplying pipe 550 and the manufacturing cost can be lowered, compared with the raw material supplying pipe and the gas supplying pipe separately provided as shown in FIG. 6.

Still further, the supplying pipe capable of enduring the high temperature is united to reduce the manufacturing cost.

Only the auxiliary chamber 110 is pressed, not the entire part of the main chamber 100, to reduce the unnecessary inert gas supply. The opening and closing of the valve is not complicated and the silicon substrate manufacturing apparatus can be operated smoothly.

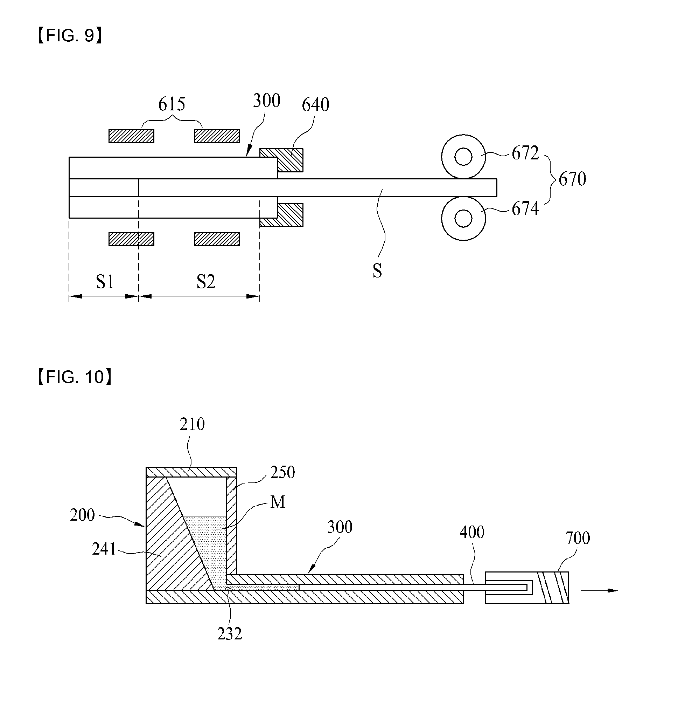

FIG. 8 is a diagram specifically illustrating the silicon substrate manufacturing apparatus the according to the embodiment shown in the first embodiment and FIG. 9 is a sectional view illustrating the molding part shown in FIG. 8.

In reference to FIG. 8, the silicon substrate manufacturing apparatus the according to the embodiment includes the crucible part 200, a heating part 610, the molding part 300, a cooling part 640 and a transporting part 670.

The crucible part 200 is described in reference to FIG. 2 and detailed description thereof will be omitted.

The heating part 610 may be installed outer to the crucible part 200. The heating part 610 may heat the crucible part 200 and it may melt the silicon raw material charged in the crucible part 200, to form the molten silicon (M).

In addition, the heating part 610 may maintain the temperature of the molten silicon (M), when the molten silicon (M) is directly supplied to the crucible part 200.

The heating part 610 includes a first heating part 612 arranged along an outside of the side surface 250 constituting the crucible part and a second heating part 614 arranged along an outside of the bottom surface 230 constituting the crucible part.

The first heating part 612, the second heating part 614 and a third heating part 260 may have a heater and an induction coil.

The first heating part 612 and the second heating part 614 may be controlled independently and a temperature difference of the molten silicon (M) inside the crucible part 200 may be reduced accordingly.

The temperature of the molten silicon (M) may be 1300∼1500°C to prevent solidification of the molten silicon (M) within the crucible part 200 and to prevent increase of the cost taken to heat the molten silicon (M) to maintain the temperature.

The molding part 300 may be extended from the outlet 232 in a parallel direction with respect to the outlet 232 of the crucible part and it may have a molding space where the silicon substrate (S) is formed. The molding part 300 may include an auxiliary heating part 615 to control the temperature for solidifying the silicon substrate (S) inside the molding space.

As shown in FIG. 9, the molding space may be divided into a solidification region (S1) to cool and solidify the silicon substrate (S) and a stress releasing region (S2) to release stress remaining in the solidified silicon substrate (S).

The solidification region (S1) starts at an area of the molding part 300 adjacent to the outlet 232 to an area in front of the molding part 300 in a moving direction of the silicon substrate (S).

In the solidification region (S1), the molten silicon (M) supplied from the outlet 232 may be solidified primarily. Although not shown in the drawing, a straight distance between both ends of the solidification region (S1) may be longer than a straight distance between both ends of the outlet 232.

The stress releasing region (S2) starts at an area adjacent to the solidification region (S1) to an area behind the molding part 300.

In the stress releasing region (S2), the silicon substrate (S) may be annealed secondarily to release the stress of the silicon substrate (S) and to prevent the solidified substrate from rapidly being cooled.

The auxiliary heating part 615 may include a first auxiliary heating part 616 and a second auxiliary heating part 617.

The first auxiliary heating part 616 may be installed corresponding to the solidification region (S1) and it may primarily heat the silicon substrate (S) located in the solidification region (S1).

The second auxiliary heating part 617 may be installed corresponding to the stress releasing region (S2) and it may heat the silicon substrate (S) located in the stress releasing region (S2).

The first auxiliary heating part 616 or the second auxiliary heating part 617 may have a heater or an induction coil.

In addition, as shown in FIG. 9, the first and second auxiliary heating parts 616 and 617 may be installed outer to the molding part 300. The position of the molding part is not limited thereto and the molding part 300 may be installed in the molding part.

When the molten silicon (M) supplied to the molding space formed in the molding part 300 is rapidly cooled or the primarily solidified silicon substrate (S) is cooled rapidly, the size of the grain generated in the silicon substrate (S) might be smaller than the required size or the remaining stress might be enlarged. To prevent that, the first auxiliary heating temperature achieved by the first auxiliary heating part 616 may be the silicon melting temperature or higher and the second auxiliary heating temperature achieved by the second auxiliary heating part 617 may be lower than the silicon melting temperature.

Accordingly, the temperature at which the silicon substrate is solidified may be controlled by the auxiliary heating part 615 and the grain size of the silicon substrate may be enlarged accordingly, to prevent the stress fro remaining.

The cooling part 640 may be installed at a rear end of the molding part 300. Also, the cooling part 640 may cool the silicon substrate (S) molded in the molding part 300 below 200°C.

The transporting part 670 may be installed behind the molding part 300 and it may move the silicon substrate (S) solidified in the molding part 300 in a horizontal direction.

The transporting part 670 may have a pair of transfer rollers 672 and 674 rotated in a reverse direction.

The transfer speed of the silicon substrate (S) transferred by the transfer rollers 672 and 674 may be identical to the silicon solidifying speed.

The transfer speed of the silicon substrate transferred by the transfer part 670 may affect the thickness of the silicon substrate and it may be 10 cm/min or less.

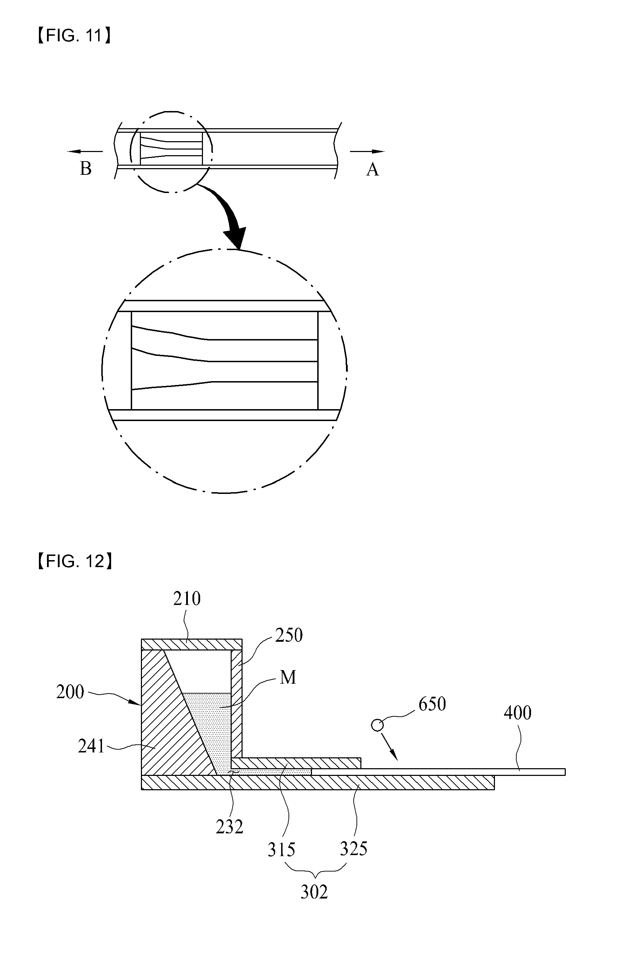

FIG. is a diagram schematically illustrating a silicon substrate manufacturing apparatus according to a still further embodiment of the invention. FIG. 11 is a diagram schematically illustrating a moving direction of a dummy bar shown in FIG. 10 and a grain of the silicon substrate.

The silicon substrate manufacturing apparatus according to this embodiment is similar to the silicon substrate manufacturing apparatus described in reference to FIG. 2 and description of the same component elements will be omitted accordingly.

In reference to FIG. 10, the silicon substrate manufacturing apparatus according to this embodiment may further include a dummy bar 400, different from the apparatus described in reference to FIG. 8.

The dummy bar 400 may be inserted in the molding space of the molding part 300 from an end at which the silicon substrate (S) formed in the molding space of the molding part 300 is moved.

The dummy bar 400 may be formed of a single-crystalline material.

The single-crystalline material may be single crystalline silicon or single-crystalline germanium.

In other words, the dummy bar 400 may be formed of graphite and the single-crystalline material is bonded to an end of the dummy bar 400.

The dummy bar 400 may have a corresponding shape with respect to the molding space of the molding part 300.

The dummy bar 400 may be inserted in the molding space of the molding part 300 and the molten silicon (M) formed in the crucible part 200 may contact with an end of the dummy bar 400.

As shown in FIG. 11, the growth direction (B) of the grains generated in the silicon substrate formed by surface-contacting the molten silicon from the end of the dummy bar 400 may be substantially perpendicular to the end of the dummy bar. In other words, a solid-liquid interface between the liquid molten silicon and the silicon substrate may be perpendicular to the growth direction of the silicon grains.

In addition, the dummy bar 400 formed of single-crystalline may enable the grains of the single-crystalline silicon aligned in a single direction, compared with the dummy bar formed of polycrystalline silicon, such that the grains of the silicon substrate may be enlarged.

The single direction in which the grains of the silicon substrate formed in the molding part 300 are aligned may be a longitudinal direction of the molding part.

The silicon substrate manufacturing apparatus according to this embodiment uses the dummy bar formed of the single-crystalline material. Accordingly, the manufactured silicon substrate may enlarge the grains of the silicon, compared with the grains of the silicon according to the conventional RGS method.

As a result, a solar battery having high energy conversion efficiency may be manufactured.

Meanwhile, in the vertical growth method of the conventional method of directly manufacturing the silicon substrate, the fabricated silicon substrate may be moved upwardly and there is a problem of a long time taken to manufacture the silicon substrate.

The silicon substrate manufacturing substrate according to this embodiment may enable the crystalline growth direction of the silicon and the solid-liquid interface to be maintained in vertical direction and it may enhance productivity, compared with the conventional silicon substrate manufacturing apparatus according to the direct manufacturing method.

In other words, the grain size of the silicon may be enlarged and the silicon substrate productivity may be enhanced simultaneously.

Meanwhile, the crucible part 200 may include a top surface 210, side surfaces 250 extended from the top surface 210 in a downward direction and an inclined part 241 having a slope of an acute angle with respect to one of the side surfaces 250.

Accordingly, the molten silicon is flowing into the molding space along the inclined part 241 of the crucible part and the silicon substrate can be manufactured by the dummy bar, without a structure provided in the bottom surface of the molding or the crucible part to transfer the silicon substrate.

Also, as shown in FIG. 4, the crucible part 202 may include the first crucible part 203 and the second crucible part 203 having the second inclined part 245.

As a result, although the first crucible part 203 has not inclined part, the second crucible part 245 has the second inclined part 245 to enable the silicon substrate to be formed by using the dummy bar, without the structure provided in the bottom surface of the crucible part or the molding part to transfer the silicon substrate.

FIG. 12 is a diagram illustrating a silicon substrate manufacturing apparatus according to a still further embodiment.

The silicon substrate manufacturing apparatus according to this embodiment is similar to the silicon substrate manufacturing apparatus according to the embodiment described in reference to FIG. 10 and detailed description of the same component elements will be omitted.

In reference to FIG. 12, the silicon substrate manufacturing apparatus according to this further embodiment includes a crucible part 200, a molding part 302, a dummy bar 400 and a cooling part 650.

The crucible part 200 may have an outlet 232 formed through a predetermined portion of the crucible part 200, in parallel to the bottom surface thereof.

The crucible part 200 may include a top surface 210, side surfaces 250 extended from the top surface 210 in a downward direction and an inclined part 241 having a slope of an acute angle with respect to one of the side surfaces 250.

The molding part 302 may be extended from the outlet 232 in a parallel direction with respect to the outlet 232 of the crucible part and it may have a molding space in which the silicon substrate is formed.

The molding part 302 may include a first molding part 315 extended from a side surface 250 facing the inclined part 241 in a perpendicular direction and a second molding part 325 coupled to the inclined part 241, extended in a parallel to the first molding part 315.

The first molding part 315 may be shorter than the second molding part 325 with respect to the outlet 232.

Different from the first molding part shown in FIG. 10, the first molding part 315 may not be positioned in a predetermined area of the region in which the molten silicon is converted into the silicon substrate.

In other words, an upper area of the molding space may be partially exposed.

The dummy bar 400 may be inserted in the molding space from a predetermined portion of the molding part 302.

The cooling part 650 may be installed adjacent to the molding part.

Also, the cooling part 650 may include a gas blowing part to blow gas.

The gas blowing part may blow gas toward the area having no first molding part 315 toward the molding space.

The gas may be an inert gas and the inert gas may be helium, argon or nitrogen or a mixture of them.

The cooling part may not be limited thereto and it may have a mechanism having a cooling channel.

In another aspect of the invention, the silicon substrate manufacturing apparatus may cool the dummy bar or the silicon substrate via an upper portion of the molding part, when the silicon substrate is formed in the molding space.

In other words, the cooling part 650 blow the gas toward the dummy bar or silicon substrate partially exposed from the molding part to cool the silicon substrate.

The silicon substrate manufacturing apparatus according to this embodiment has an advantage of no dummy bar coupling part or auxiliary cooling device provided at an end of the molding part.

In addition, air cooling may be performed, rather than water cooling, to reduce the cooling cost.

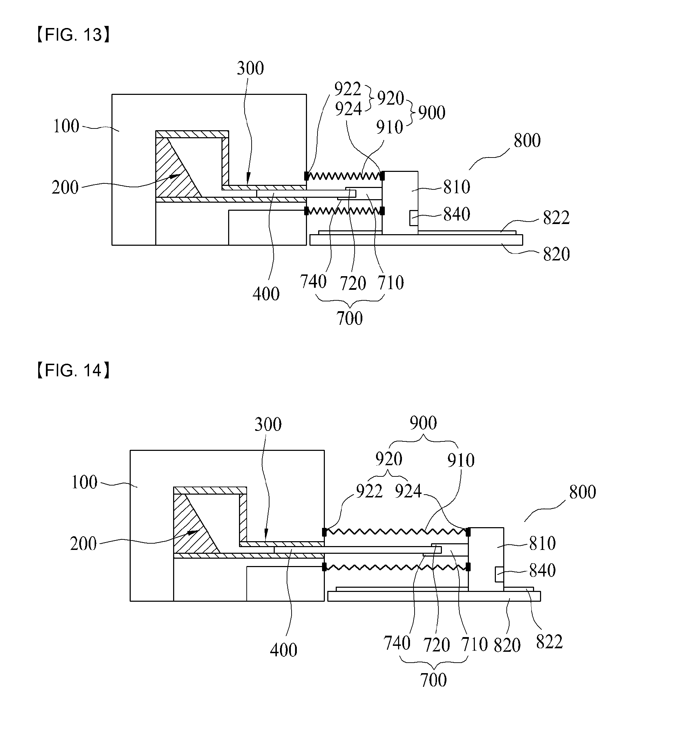

FIG. 13 is a diagram illustrating a silicon substrate manufacturing apparatus according to a still further embodiment.

In reference to FIG. 13, the silicon substrate manufacturing apparatus further include a dummy bar coupling part 700, a moving part 800 and a closable part 900, different from the apparatus according to the embodiment described in reference to FIG. 11.

The dummy bar coupling part 700 may be coupled to the dummy bar 400 and it may be formed of graphite.

The dummy bar coupling part 700 and the dummy bar may be coupled to each other by a bolt.

The dummy bar coupling part 700 may have a clamp shape.

The dummy bar coupling part 700 may include a coupling body 710, an upper coupling portion 720 that is able to surface-contact with an upper surface of the dummy bar and a lower coupling portion 740 that is able to surface-contact with a lower surface of the dummy bar 400, in parallel to the upper coupling portion.

The upper coupling portion 720 and the lower coupling portion 740 may be formed of a predetermined material having elasticity.

Accordingly the upper coupling portion 720 and the lower coupling portion 740 may prevent the shock applied to the dummy bar 400 when they are in surface-contact with the dummy bar 400.

Also, the upper coupling portion 720 and the lower coupling portion 740 presses the dummy bar 400 in an up-and-down direction, such that the dummy bar coupling part 700 may be coupled to the dummy bar 400.

Although not shown in the drawing, the dummy bar coupling part 700 may have a cooling channel.

A fluidal material flows via the cooling channel in the dummy coupling part 700, to lower the temperature of the dummy coupling part 700 and to lower the temperature of the dummy bar 400 coupled to the dummy coupling part 700 accordingly.

As a result, the temperature of the dummy bar 400 may be lowered and a latent heat of the molten silicon within the molding part may be removed, to solidify the silicon substrate.

Meanwhile, the cooling channel is provided in the dummy bar coupling part 700 and an unnecessary heat can be removed, only to prevent the neighboring graphite from contaminating the silicon substrate.

The moving part 800 may be connected with the dummy bar coupling part 700, to move the dummy bar coupling part 700 horizontally.

The moving part 800 includes a moving body 810, a moving support 820 and a driving part 840.

The moving body 810 is connected with the dummy bar coupling part 700.

The moving support 820 may support the moving body 810 and it may have a rail 822. Although not shown in the drawing, the moving body 810 may have a wheel corresponding to the rail 822.

Meanwhile, the moving support 820 may have all types of mechanisms enabling the moving support to move the moving body, not limited to the rail 822.

The driving part 840 is installed in the moving body 810 and it provides a rotational force to the wheel. In other words, the wheel rotatable by the driving part 840 may be rotated along the rail 822.

Accordingly, the moving part 800 may be moved horizontally to insert the dummy bar 400 coupled to the dummy bar coupling part 700 in the molding part 300 or withdraw it from the molding part 300.

Different from the transfer part having the pair of the rollers shown in FIG. 9, the dummy bar coupling part 700 and the moving part 800 that consists of the mechanism capable of pulling the dummy bar are provided in the silicon substrate manufacturing apparatus according to this embodiment such that damage to the molded silicon substrate caused by the roller may be prevented.

Meanwhile, the silicon substrate manufacturing apparatus according to this embodiment may further include a main chamber 100 to accommodate the crucible part 200 and the molding part 300.

The closable part 900 may be next to the main chamber 100 and it may cover an outer portion of the dummy bar coupling part 700, expandable in a longitudinal direction of the dummy bar 400.

Also, the closable part 900 may be a bellows as shown in FIG. 13.

The closable part 900 may be formed of stainless steel or aluminum alloy. The stainless steel may be an alloyed steel of iron and chrome or an alloyed steel of iron, nickel and chrome. The material used for the closable part is not limited to the stainless steel or aluminum alloy and it may be a metallic material capable of enduring the heat generated from the side of the molding part 300, with high corrosion resistance.

The closable part 900 may have an expandable part 910 and a connecting part 920.

As shown in FIG. 14, the expandable part 910 may be expandable as far as the dummy bar coupling part 700 is movable horizontally on the moving support 820. Accordingly, the expandable part 910 may be expanded or contracted, corresponding to the horizontal movement of the dummy bar coupling part 700, such that external air may be prevented from coming into the expandable part 910.

Also, the connecting part 920 may include a first connecting part 922 to connect the main chamber 100 and the expandable part 910 with each other and a second connecting part 924 to connect the moving part 800 and the expandable part 910 with each other.

The first connecting part 922 or the second connecting part 924 may have a groove corresponding to a bolt enabling bolt fastening. The closable part 900 may be coupled to or separated from the portion of the main chamber 100 or the moving part 800 when necessary.

In another aspect of the invention, the closable part 900 may enable the dummy bar coupling part 700 to be arranged in the airtight space.

The silicon substrate manufacturing apparatus according to this embodiment may include the closable part 900 installed outer to the dummy bar coupling part 700. Accordingly, the dummy bar coupling part formed of graphite may be prevented from being oxidized after contacting with external air.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. An apparatus for manufacturing a silicon substrate comprising:
a crucible part;
a molding part extended from an outlet of the crucible part, the molding part comprising a molding space where a silicon substrate is formed; and
a dummy bar inserted in the molding space from a predetermined portion of the molding part,
wherein the dummy bar is formed of a single-crystalline material.

2. The apparatus for manufacturing the silicon substrate according to claim 1, wherein the single-crystalline material is single-crystalline silicon.

3. The apparatus for manufacturing the silicon substrate according to claim 1, further comprising:
a dummy bar coupling part that is able to be coupled to the dummy bar.

4. The apparatus for manufacturing the silicon substrate according to claim 3, further comprising:
a driving part to drive the dummy bar coupling part to be movable in a longitudinal direction of the molding part.

5. The apparatus for manufacturing the silicon substrate according to claim 1, wherein the crucible part comprises a top surface, side surfaces extended from the top surface in a downward direction, a bottom surface extended from the side surfaces in a perpendicular direction and an inclined part having a slope of an acute angle with respect to one of the side surfaces.

6. The apparatus for manufacturing the silicon substrate according to claim 3, further comprising:
a closable part arranged adjacent to the molding part to cover an outside of the dummy bar coupling part, the closable part that is expandable and contractible in a longitudinal direction of the dummy bar.

7. The apparatus for manufacturing the silicon substrate according to claim 1, wherein the crucible part comprises a first crucible part and a second crucible part, and
the first crucible part comprises a top surface, side surfaces extended from the top surface in a downward direction, a bottom surface extended from the side surfaces in a perpendicular direction and a first outlet formed through a predetermined portion thereof in a parallel direction with respect to the bottom surface, and
the second crucible part is insertedly coupled to the first crucible part and the second crucible part comprises a second inclined part connected with the bottom surface, with a slope of an acute angle with respect to an upper portion of the top surface provided in the first crucible part.

8. The apparatus for manufacturing the silicon substrate according to claim 1, further comprising:
a main chamber to provide an airtight space, wherein the crucible part comprises a raw material injecting part provided in the main chamber, having a raw material injecting hole passing through an upper portion thereof, and a gas injecting part spaced apart a predetermined distance from the raw material injecting hole, having a gas injecting hole passing through an upper portion thereof;
a raw material supplying part comprising a raw material supplying body arranged on the main chamber to store a silicon raw material, a raw material supplying pipe to connect the raw material supplying body and the raw material injecting part with each other and a first valve to control opening and closing of the raw material supplying pipe; and
a gas supplying part to supply an inert gas to the crucible part.
